# EUROPEAN PATENT APPLICATION

(11) **EP 3 576 503 A1**
(43) Date of publication of application: **04.12.2019**
(21) Application number: 18382377.2
(22) Date of filing: 31.05.2018
(51) Int. Cl.: H05K 1/16, H05K 3/00, H05K 3/12, H05K 3/28

(54) **IMPLEMENTATION PROCESS OF A HUMIDITY CONTROL SENSOR FOR 3D-PRINTING OF A SMART TOOL AND PROCESS FOR MANUFACTURING A HUMIDITY CONTROL SENSOR VIA 3D-PRINTING TECHNOLOGY**

(71) Applicant: Airbus Operations, S.L., 28906 Getafe (ES)
(72) Inventor: JARA RODELGO, Alvaro, 28906 GETAFE (ES); TORRES SALAS, Álvaro, 28906 gETAFE (ES); LLORENTE GARCÍA, Paloma, 28906 GETAFE (ES); MOYA SANZ, Elena, 28906 GETAFE (ES)

(57) **Abstract**

The invention is relative to a process to manufacture a humidity control tool via 3D-printing technology comprising the following steps:
- 3D-print (**100**) onto a PCB (**105)** a first electrode via the 3D-printing of layers (110) based on a conductive material (**12a**);
- 3D-print (**200**) onto a region of the first electrode (**120**), a dielectric layer (**130**) of insulating 3D-material (**12b, 12c**);
- 3D-print (**300**) onto the dielectric layer (**130**) a second electrode (**140**) based on a conductive material (**12a**) and having a permeability to the moisture greater than the dielectric layer (**130**) with which it is in contact;

## Description

### FIELD OF THE INVENTION

The present invention relates to an implementation process of an electronic component such as a humidity control sensor during a 3D-printing of a smart tool or device, and more particularly a process for manufacturing a humidity control sensor via 3D-printing technology.

### BACKGROUND

Nowadays the 3D-printing technology is known and well know, but it's difficult today to manufacture a tool or device via 3D-printing being sure that this tool or device will keep its integrity and viability during its life cycle. Indeed, the material used in order to 3D-print are susceptive to absorb humidity which could have a real impact on the reliability of this kind of tool or device. One potential solution could be to implement a classic electronic humidity control sensor able to detect the threshold of humidity of the said tool or device in order to change or throw it. But unfortunately, the modules able to cure the ongoing 3D-printing of the smart tool or device region-by-region, with ultraviolet radiation or laser beam burn directly all classic electronic component, such as the humidity control sensor.

### SUMMARY OF THE INVENTION

In order to solve the drawback stated above, the present invention proposes a process for manufacturing a humidity control sensor via 3D-printing technology, according to a set of claims, comprising at least the following steps:
- 3D-print onto a PCB a first electrode via the 3D-printing of layers based on conductive material;
- 3D-print onto a region of the first electrode, a dielectric layer of insulating 3D-material;
- 3D-print onto the dielectric layer a second electrode based on conductive material and having a permeability to the moisture greater than the dielectric layer with which it is in contact;
In an embodiment of the invention, the conductive material used for the 3D-printing is a polymer material mixed with powdered graphene, such as to increase or decrease the thermal and/or electrical conductivity according to the need;
In an embodiment of the invention, the 3D-printing of the framework of the smart tool or device and comprising the humidity control sensor, is able to be designed or restyled on an ad-hoc basis;
In an embodiment of the invention, the polymer material used to manufacture the humidity control sensor is based on PLA (Polylactic Acid) or ABS (Acrylonitrile Butadiene Styrene) and/or Polyetherimide;
In an embodiment of the invention, the manufacturing process of a humidity control sensor comprises additional steps such as 3D-print on the PCB:
- a set of sensors able to be connected to the electrodes of the humidity control sensor, in order to assess the humidity;
- a set of digital and/or analogic electronic components able to operate respectively digital or analogic signals from the set of sensors;
- at least one IHM (Interface Human Machine) able to allow to an operator or an automaton to interact with the sensors connected to the humidity control sensor;
- at least one conductive trace able to be connected from the humidity control sensor to the set of sensors to respectively the set of digital and/or analogic electronic components, and at least one IHM.
- at least one component of the set of digital and/or analogic components is manufactured via 3D-printing.
- at least one component is a 3D printed Surface-Mount Component (SMT);
- the humidity control sensor is connected to a 3D printed antenna;
- the 3D-printed antenna is a RFID (Radio Frequency Identification);
- the conductive trace has a thermal or electrical conductivity;
- the IHM can be a buzzer, and/or a display interface such as LCD or a set of Led;

The invention has also as object an implementation process of a classic electronic component during a 3D-printing of smart tool, said 3D-printer comprising at least a robotized arm with prehension means and following the following steps:
- Synchronization of the robotized arm with the movement of the set of 3D-printing heads, or the printing bed.
- the prehension means catch a classic electronic component from a receptacle,
- the prehension means implement the said classic electronic component onto a 3D-printed PCB.
- discharge via the 3D-printing head a thermoplastic based from Polyetherimide to form a protective layer on the top of the classic electronic component, in order to protect it from ultraviolet radiations and laser beam.
- the classic component is a humidity control sensor.
- the Polyetherimide used in order to protect the top of the electronic component is ULTEM1010™.

### BRIEF DESCRIPTION OF THE DRAWINGS

To complete the description and in order to provide for a better understanding of the invention, a set of drawings is provided. Said drawings form an integral part of the description and illustrate preferred embodiments of the invention. The drawings comprise the following figures:
- Figure 1, is a schematic representation of the main elements of a 3D-printer according to the invention;
- Figure 2, is a schematic representation of an embodiment of a humidity control sensor according to the manufacturing process of the present invention.

### DETAILED DESCRIPTION OF THE INVENTION

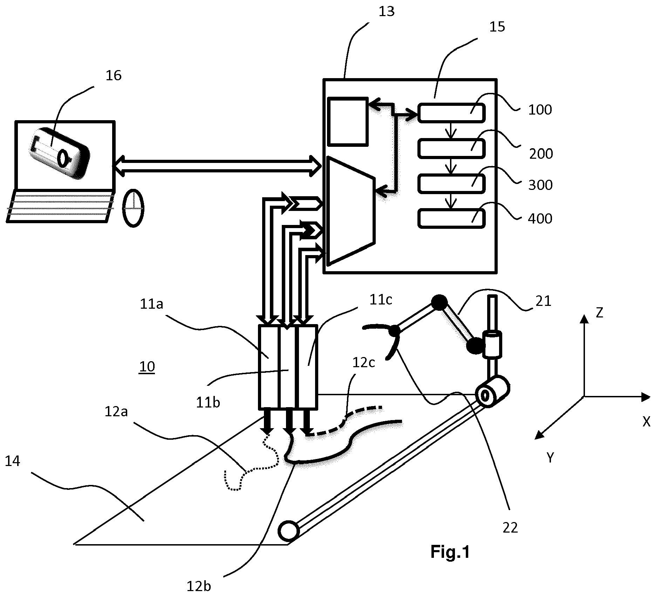

The present invention is directed generally towards an implementation process of a humidity control sensor during a 3D-printing of a smart tool, and particularly to the manufacturing process of a humidity control sensor. A person skilled in the relevant art will understand, however, that the invention may have additional embodiments, and that the invention may be practiced without several of the details of the embodiments described below with reference to figures 1-2.

3D (Three Dimensions) printing, also known as additive layer manufacturing, is increasingly taking importance in all the different industrial sectors. There is infinity of possible applications such as the manufacturing of tools, jigs, parts of simple or complex structure, designed according to the needed. This manufacturing via 3D-printing technologies is used especially with the so called Fused Deposition Modelling (FDM) as represented in figure 1.

The Fused Deposition Modelling (FDM), also called FFF (Fused Filament Fabrication) or PJP (Plastic Jet Printing) is an additive manufacturing technology. Additive manufacturing technology is commonly used for thermoplastics 3D-printing with special focus on modeling, prototyping and production applications. The additive manufacturing technology is able to print 3D parts by printing 2D (Two Dimensions) continuous thickness layer, usually called 2,5D (2.5 Dimensions) as there is no coordinated movement in 3D.

The 3D-printing material used to 3D-print consists on a polymer base which can be PLA (Polylactic Acid) or ABS (Acrylonitrile Butadiene Styrene). According to the rest of the description the 3D-printing material used for the invention will be considered as thermoplastic material.

According to the invention, the polymer base can be powdered with graphene in order to modify some of its properties. Indeed, graphene is a nanomaterial, discovered in 2004, consisting on a one-atom-thick planar sheet of bonded carbon atoms that are densely packed in a honeycomb crystal lattice. Graphene is a basic structural element of some variants carbon such as graphite, charcoal, nanotubes, and fullerenes. Graphene has an unique electronic and mechanical properties, such as:
- a transparency and a flexibility;
- a very high thermal and electrical conductivity. Indeed, graphene has a higher conductivity than Cu (copper) or Ag (silver);
- a high elasticity and hardness. Indeed, it is considered as the hardest material ever known;
- a very big lightness. Indeed, graphene is quite as light as the carbon fiber but more flexible;
- enables electrons to flow much faster than silicon;

Consequently, the addition of graphene to some material increases their potential and allows new 3D-printing applications.

Furthermore, graphene opened new ways and new possibilities for the manufacturing of electronic components. Indeed, it is possible to print on sheet active or passive electronic components with graphene, such as semi-conductors, dielectric-interfaces, piezoelectric substrate, transistors, integrated circuits, OLED displays, or organic photovoltaic cells.

Following the different knowledge previously cited, time is come to develop smart devices or tools via 3D-printing technology, but this perspective looks like very complex and expansive according to the state of art.

Figure 1 is a schematic representation of the main elements of a 3D-printer **10** according to the invention. The 3D-printer **10,** according to the invention, comprises at least a first 3D-printing head **11a** to selectively discharge a conductive 3D-printing material **12a** based from PLA or ABS powdered with graphene, a second 3D-printing head **11b** to selectively discharge an insulating 3D-printing material **12b** based from PLA or ABS without graphene, and a third 3D-printing head **11c** to selectively discharge an insulating 3D-material **12c** being based from Polyetherimide (such as ULTEM1010™,...) and having inflammable thermoplastic properties.

The 3D-printer **10** comprises also a processor **13** able to control the operations of the first, second and third 3D-printing heads **11a**, **11b**, **11c.** The processor **13** of the 3D-printer **10** is able to decrypt a list **15** of steps **100, 200, 300, 400** from a CAD (Computer-Aided Design) scheme **16** describing a smart tool or device including a multi-layer Printed Circuit Board (PCB) **105** intended for 3D-printing.

Following the sequential steps **100, 200, 300, 400,** each 3D-printing head **11a**, **11b**, **11c** is able to print in **X** and **Y** directions for each layer of conductive or insulating 3D-printing material **12a, 12b, 12c,** such as the 3D-print heads **11a**, **11b**, **11c** or a print bed **14** is able to move before that the following layer is printed.

In this kind of technology, the thermoplastic material filament **12a, 12b, 12c** or wire is heated pass its glass transition temperature of the material and then laid on the print bed **14** or table, where it cools down or dries and consolidates with previous layers in order to create a solid part.

According to the 3D-printer **10** of the invention, the first, second and third 3D-printing heads **11a, 11b, 11c** are able in combination to 3D-print functional passive and/or active classic electronic components, such as piezoelectric sensor, piezoelectric substrate, wafer, functional resistor, functional capacitor, functional electromagnetic waveguide, functional optical waveguide, functional antenna or protruding antenna or horn antenna, functional heat sink, functional coaxial element or coaxial cable or coaxial mesh, SMT/COB component, or equivalent. By COB component, we understand a Chip-On-Board component assembly. By SMT component, we understand a Surface-Mount Technology component assembly.

The first, second and third 3D-printing heads **11a**, **11b**, **11c** are able to 3D-print, in a same 3D-printing session, a PCB (Printed Circuit Board) **105** and an electronic component embedded within said PCB **105.** According to the invention, the processor **13** of the 3D-printer **10** is able to manage at the same time the manufacturing of the smart tool or device comprising the 3D-printing of a PCB **105** with the 3D-printing of a set of electronic components, and the implementation process of a set of classic electronic components. In the rest of the description, the term "classic electronic component" is considered as being not 3D-printed component. In the rest of description, the use of the term "electronic component" not preceded by the term "classic" is considered as being a component manufactured via the 3D-printing technology and/or classic electronic component.

The first 3D-printing head **11a** able to discharge the conductive 3D-printing material **12a** is associated with at least first and second 3D-printing nozzles (not referenced on the figures). The first 3D-printing nozzle is able to discharge the conductive 3D-printing material **12a** through a first nozzle aperture having a first diameter D1. The second 3D-printing nozzle is able to discharge the conductive 3D-printing material through a second nozzle aperture having a second, different, diameter D2. In order to switch between the at least first and second 3D-printing nozzles, the 3D-printer **10** comprises a switching module to selectively activate during a 3D-printing process, one of the first and second 3D-printing nozzles.

The second and third 3D-printing heads **11b**, **11c** able to discharge the insulating 3D-printing material **12b, 12c** are respectively associated with at least first and second 3D-printing nozzles (not referenced on the figures). The first 3D-printing nozzle is able to discharge the insulating 3D-printing material **12b, 12c** through a first nozzle aperture having a first diameter D3. The second 3D-printing nozzle is able to discharge the insulating 3D-printing material through a second nozzle aperture having a second, different, diameter D4. In order to switch between the at least first and second 3D-printing nozzles, the 3D-printer **10** uses the switching module to selectively activate during a 3D-printing process, one of the first and second 3D-printing nozzles.

In order to be more efficient, the 3D-printer **10** requires some additional modules. These modules are describes below and can be used alone or in combination with others in order to reach the goal expected. This following list of embodiments of is not exhaustive and can be completed according to the specific needs and the technological advances in the 3D-printer field.

In some embodiments, the 3D-printer **10** comprises an ultraviolet (UV) energy based curing module, to emit ultraviolet radiation in order to cure the pending 3D-printing of thermoplastic materials region-by-region.

In some embodiments, the 3D-printer **10** comprises a laser source to emit a laser beam in order to cure the pending 3D-printing of thermoplastic materials region-by-region.

In some embodiments, the 3D-printer **10** comprises a laser source to emit a targeted laser beam for curing just-dispensed of a 3D-printing of thermoplastic materials.

According to the invention, the 3D-printer **10** is able to proceed to a transition between two crossed conductive materials, with the following sequential 3D-printing steps:
- a first trace of a conductive material **12a;**
- on the top of a particular spot of the first trace, a bridge formed from an insulating material **12b,**
- on the top of the bridge, a second trace of conductive material **12a.**

In some embodiments, the 3D-printer **10** comprises an Automatic Optical Inspection (AOI) module able sequentially to:
- capture an image of a 3D-printing of a trace of conductive material **12a** during an ongoing 3D-printing session;
- compare the captured image to a reference indicating a required width of the 3D-printing of the trace of the conductive material **12a;**
- based on the comparison, determine that a width of at least a portion of the 3D-printing of the trace of conductive material **12a** is smaller than the required width;
- trigger a corrective 3D-printing operation to increase the width of said portion of the 3D-printing of the trace of conductive material **12a.**

In some embodiments, the 3D-printer **10** comprises an Automatic Optical Inspection (AOI) module sequentially able to:
- capture an image of a 3D-printing of a trace of conductive material **12a** during an ongoing 3D-printed session;
- compare the captured image to a reference indicating a required width of the 3D-printing of the trace of the conductive material **12a;**
- based on the comparison, determine that a width of at least a portion of the 3D-printing of the trace of the conductive material **12a** is greater than the required width;
- trigger a laser ablation module to decrease the width of said portion of the 3D-printing of the trace of the conductive material **12a.**

In some embodiments, the 3D-printer **10** comprises an Automatic Optical Inspection (AOI) module sequentially able to :
- capture an image of a 3D-printing of a trace of a conductive material **12a** during an ongoing 3D-printing session;
- compare the captured image to a reference indicating a required structure of the 3D-printing of the trace of the conductive material **12a;**
- based on a comparison, identify a fracture in the 3D-printing of the trace of the conductive material **12a;**
- trigger a corrective 3D-printing operation to 3D-print again, correctly, at least a region comprising said fracture.

In some embodiments, the 3D-printer **10** comprises an Automatic Optical Inspection (AOI) module sequentially able to:
- capture an image of a 3D-printing of a pad during an ongoing 3D-printing session of a 3D-printed PCB **105;** by pad we understand a portion of conductive material 12a exposed on a PCB **105** to which a classic electronic component is soldered;
- compare the captured image to a reference indicating a required structure of an expected 3D-printing of pad;
- based on the comparison, determine that the 3D-printing of the pad is excessively large;
- trigger a laser ablation module in order to decrease the size of the said 3D-printing of the pad.

In some embodiments, the 3D-printer **10** comprises a solder mask 3D-printing module able to 3D-print a solder mask with insulating material **12b, 12c** on a 3D-printing of a PCB **105,** wherein the solder mask and the PCB **105** are 3D-printed in a single, unified, 3D-printing process. The said solder mask allows to cover the different traces of conductive material **12a** on the PCB **105,** in order to protect the said traces.

In some embodiments, the 3D-printer **10** comprises a heat sink 3D-printing module to 3D-print a passive heat exchanger integrated in a pre-defined region of the 3D-printed PCB **105** with conductive material **12a.**

In some embodiments, the 3D-printer **10** comprises a thermal conductivity planner able to:
- determine that a particular region of a 3D-printed PCB **105,** located under a 3D-printed conductive pad, requires a heat transfer path with increased thermal conductivity;
- 3D-print, in a region under said 3D-printed conductive pad, with a first 3D-printing material having increased thermal conductivity relative to a second 3D-printing material used for 3D-printing at a surrounding region which does not require a heat transfer path with increased thermal conductivity.

In some embodiments, the 3D-printer **10** comprises an embedded SMT component 3D-printing module, to 3D-print a 3D-printed PCB **105** having a fully-buried (unexposed) 3D-printed Surface-Mount Technology (SMT) component.

In some embodiments, the 3D-printer **10** comprises a pause-and-resume 3D-printing controller, able to:
- pause a 3D-printing process of a PCB **105,** and
- wait until an implementation process of a COB/SMT or a set of electronic component onto the already-3D-printed portion of the PCB **105.**

In some embodiments, the 3D-printer **10** comprises a module able to modify the trace width/thickness, during a 3D-printing process of a trace of conductive material **12a,** at least one of :
- a width of the trace of conductive material **12a** being 3D-printed, and
- a thickness of the trace of the conductive material **12a** being 3D-printed;
wherein said module is able to modify the width/thickness trace of the conductive material **12a** in order to maintain the current-carrying capacity of said trace.

In some embodiments, the 3D-printer **10** comprises a module able to modify the rigidity and/or flexibility when said 3D-printer **10** needs to 3D-print a PCB **105** having a gradually-changing level of rigidity.

In some embodiments, the 3D-printer **10** comprises a module able to modify the rigidity and/or flexibility when said 3D-printer **10** needs to 3D-print a PCB **105** having an abruptly-changing level of rigidity.

In some embodiments, the 3D-printer **10** comprises a module able to modify a dielectric material thickness when said 3D-printer **10** needs to 3D-print, between a first 3D-printed conductive layer and a second, neighboring, non-parallel, 3D-printed conductive layer, a dielectric material having varying thickness.

As mentioned before, the materials ABS or PLA used in FDM in order to manufacture via 3D-printing the smart tool are susceptible to lost or decrease their properties due to the moisture absorption from the environment where they are used or conserved. The moisture absorption of the smart tool or device has a real impact on the life cycle of this kind of smart tool or device via 3D-printing technology, because the integrity of the material properties and the working reliability is engaged. In order to avoid this drawback, the invention propose to implement at least one humidity control sensor inside the 3D-printing smart tool, in order to assess the moisture absorption and act accordingly. According to the invention, the said humidity control sensor is connected to a PCB 105 and a set of components **410, 420, 430** in order to be able to interact with at least an operator and/or a humanoid.

In some embodiments of the invention, the Humidity Control Sensor is a classic electronic component. According to the invention, in order to implement a classic electronic component, the 3D-printer **10** comprises at least a robotized arm **21** with means of prehension **22.** The robotized arm **21** is able to move in **X,** and/or **Y** and/or **Z** directions and is synchronized with the movement of the set of heads **11a**, **11b**, **11c**, or the print bed **14,** in order to avoid to disturb the 3D-printing. According to the invention, the robotized arm **21** with the prehension means **22** are able to follow the sequential steps **100, 200, 300, 400,** in order to catch a classic electronic component from a receptacle (not referenced), then to proceed to the implementation of the said classic electronic component onto the 3D-printed PCB **105.**

The implementation of the classic electronic component onto the PCB **105** raises a real problem and not the least. Indeed, according to the invention, the modules able to cure the ongoing 3D-printing of thermoplastic materials (ABS, PLA) region-by-region burn the classic electronic component. In order to overpass this drawback and after many experimentations, it appears that Polyetherimide thermoplastic were the more accurate regarding their properties and chemical stability when they are submit to high temperature as the curing phase. Particularly, the Polyetherimide ULTEM1010™ seems to be the best option. Accordingly, the invention propose that after each implementation of classic electronic component onto the PCB **105,** the 3D-printing head **11c** discharge a thermoplastic **12c** based from Polyetherimide to form a protective layer on the top of the classic electronic component, in order to protect it from ultraviolet radiations and laser beam.

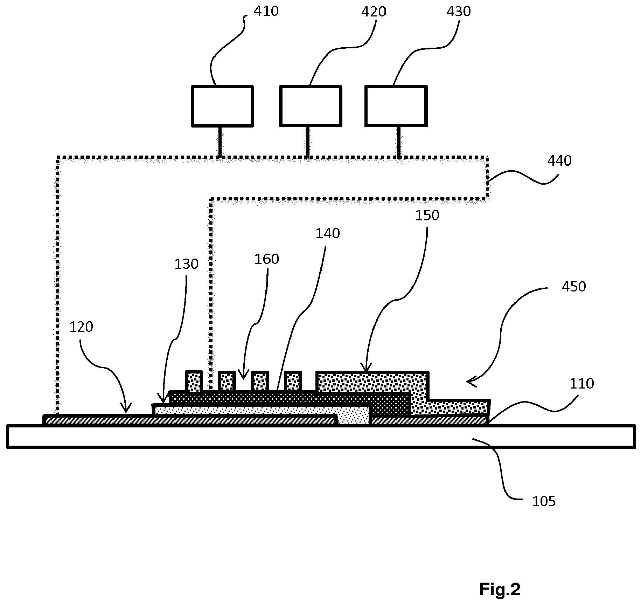

According to a preferred embodiment of the invention, the 3D-printer **10** is able to 3D-print a humidity control sensor, as shown in Figure 2, in order to replace the classic electronic version. According to the invention, the manufacturing process comprises the following steps:
- 3D-print **100** onto a PCB **105** a first electrode via the 3D-printing of layers **110** based on conductive material **12a;**
- 3D-print **200** onto a region of the first electrode **120,** a layer **130** of insulating 3D-material **12b, 12c;**
- 3D-print **300** onto the layer **130** a layer **140** based on conductive material **12a** and having a permeability to the moisture greater than the layer **130** with which it is in contact;

The main advantage of the manufacturing process according to this embodiment is the possibility to use the ALM (Additive Layer Manufacturing) in order to manufacture/3D-print quickly any simple or complex smart tool or device with at least one humidity control sensor embedded with features and/or framework according to an ad-hoc design. Another advantage of this embodiment is the possibility to modify the shape or restyle partially or totally the framework of the smart tool or device able to receive the humidity control tool according to the invention.

The humidity control sensor according the manufacturing process of the invention is laydown on a PCB 105. The said PCB **105** is based on polymer material **12b** or **12c** such as PLA, ABS or Polyether. The humidity control sensor comprises a first electrode **120,** also referred as the "bottom electrode", resting onto the PCB **105.** The first electrode **120** is formed of at least one layer **110** based from conductive material **12a,** such as polymer material like ABS or PLA powdered with graphene. On a region of this layer **110** is disposed at least one layer **130** of insulating material **12b, 12c** used as dielectric material. This layer **130** may be a material that is only slightly absorbent or slightly permeable or even impermeable to moisture such as insulating material **12b** as PLA or ABS or **12c** as Polyetherimide.

The region of the layer **130** is covered with a second electrode **140,** also referred to as the "top electrode". The second electrode **140** is formed from layers of conductive material **12a,** where the permeability to the moisture is higher than that of the layer **130.**

The first electrode **120,** the layer **130** and the second electrode **140** form a capacitance which is variable according to the humidity.

Indeed, in order to be able to detect the presence of moisture or humidity, the layer **130** is made with the main material used to manufacture the smart tool or device. Therefore, when some humidity appears inside the smart tool or device, the interface between the electrodes **120, 140,** based on conductive material **12a** powdered with graphene, and the layer **130** considered as dielectric material, become semi-conductive in contact with H2O molecules.

Because of moisture absorbent character of the second electrode **140,** and the weakly absorbent or non-absorbent character of the layer **130,** the variation in capacitance able to be detected by means of such sensors 410 depend on a variation in moisture close to the interface between the second electrode **140** and the layer **130.**

The second electrode **140** may be covered with a perforated hydrophobic protective layer **150,** such as insulating material **12c,** comprising openings **160** through which the moisture is intended to enter.

According to the invention, as shown in figure 2, the humidity control sensor **450** is able to be connected to the PCB **105** 3D-printed, partially or totally embedded within of the framework of the smart tool or device such as on the PCB **105** is connected:
- a set of sensors **410** able to be connected to the electrodes **120, 140** in order to measure the values in order to define the humidity rate;
- a set of digital and/or analogic electrical components **420** able to operate respectively digital or analogic signals from the set of sensors **410;**
- at least one IHM (Interface Human Machine) **430** able to allow to an operator or an automaton to interact with the sensors **410** of the humidity control sensor **450;**
- at least one conductive trace **440** able to be connected from the Humidity control sensor **450** to the set of sensors **410,** to respectively the set of digital and/or analogic components **420,** and to at least one IHM **430.**

One main advantage of this embodiment is to confer some smart properties to the humidity control sensor **450** in order to interact with an operator or an automaton by itself or from a request. Indeed, the operator or the automatons are able to interact directly or indirectly with the humidity control sensor **450** via IHM **430** or communication means.

According to the invention, at least one component of the set of digital and/or analogic electrical components **420** is manufactured via 3D printed graphene.

According to the invention, at least one component **420** is a 3D printed Surface-Mount Component (SMT) or a Chip On Board (COB);

According to the invention, the humidity control sensor **450** is connected to a 3D-printed antenna;

According to the invention, the 3D-printed antenna is a RFID (Radio Frequency Identification). One main advantage with the RFID antenna is the ability to transmit, receive and store remote data quickly to a humanoid or an automaton able to communicate with said humidity control sensor **450.**

According to the invention, the conductive trace **440** has a thermal and/or electrical conductivity; the 3D-printer **10** is able to add more or less graphene powder in the conductive material **12a** in order to obtain a trace **440** with a better thermal or electricity conductivity.

According to the invention, the IHM **430** can be a buzzer, and/or a display interface such as LCD or a set of Led to interact easily with the human operator; In the case of the humanoid or automaton, the communication means are more useful in order to have an interaction with the humidity control sensor **450.**

By operator we understand a human or humanoid entitled and able to handle with his hand said smart tool or device comprising the humidity control sensor **450.** By automaton we understand a self-operating machine, or a machine, or a control mechanism designed to automatically follow a predetermined sequence of operations, or respond to predetermined instructions.

According to the invention, the smart tool or device comprises a part relative to an electric battery in order to feed all the consumers, such as the set of sensors **410,** the set of digital and/or analogic electronic components **420,** and the set of IHM **430.** According to the invention, the battery is rechargeable.

From the foregoing, it will be appreciated that specific embodiments of the invention have been described herein for purposes of illustration, but that various modifications may be made without deviating from the spirit and scope of the invention. For example, aspects of the invention described in the context of particular embodiments may be combined or eliminated in other embodiments. Although advantages associated with certain embodiments of the invention have been described in the context of those embodiments, other embodiments may also exhibit such advantages. Additionally, none of the foregoing embodiments need necessarily to exhibit such advantages to fall within the scope of the invention. Accordingly, the invention is not limited except as by the appended claims.

## Claims

1. Process for manufacturing a humidity control sensor via 3D-printing technology comprising the following steps:
- 3D-print (**100**) onto a PCB (**105**) a first electrode via the 3D-printing of layers (**110**) based on a conductive material (**12a**);
- 3D-print (**200**) onto a region of the first electrode (**120**), a dielectric layer (**130**) of insulating 3D-material (**12b**, **12c**);
- 3D-print (**300**) onto the dielectric layer (**130**) a second electrode (**140**) based on a conductive material (**12a**) and having a permeability to the moisture greater than the dielectric layer (**130**) with which it is in contact;

2. Process for manufacturing a humidity control sensor (**450**) via 3D-printing technology according to claim 1, wherein the conductive material (**12a**) used for the 3D-printing is a polymer material mixed with powdered graphene, in order to increase or decrease the thermal and/or electrical conductivity according to the need.

3. Process for manufacturing a humidity control sensor (**450**) via 3D-printing technology according to claim 1 or 2, wherein the 3D-printing of the framework of the smart tool or device comprising the humidity control sensor (**450**) is designed or restyled on an ad-hoc basis.

4. Process for manufacturing a humidity control sensor (**450**) via 3D-printing technology according to claims 1 to 3, wherein the polymer material used to manufacture the humidity control sensor (**450**) is based on PLA (Polylactic Acid) or ABS (Acrylonitrile Butadiene Styrene) and/or Polyetherimide.

5. Process for manufacturing a humidity control sensor (**450**) via 3D-printing technology according to claims 1 to 4, wherein it comprises additional steps in order to 3D-print a PCB (**105**) partially or totally embedded within a protective framework able to receive the humidity control tool, such as the PCB (**105**) comprises:
- a set of sensors (**410**) able to be connected to the electrodes (**120, 140**) in order to assess the humidity;
- a set of digital and/or analogic electronic components (**420**) able to operate respectively digital or analogic signals from the set of sensors (**410**);
- at least one IHM (Interface Human Machine) (**430**) able to allow to an operator or an automaton to interact with the sensors (**410**) of the humidity control sensor (**450**);
- at least one conductive trace (**440**) able to be connected from the humidity control sensor to the set of sensors (**410**) to respectively the set of digital and/or analogic electronic components (**420**), and at least one IHM (**430**).

6. Process for manufacturing a humidity control sensor (**450**) via 3D-printing technology according to claim 5, **characterized in that** at least one component of the set of digital and/or analogic components (**420**) is manufactured via 3D-printing.

7. Process for manufacturing a humidity control sensor (**450**) via 3D-printing technology according to claims 5 or 6, **characterized in that** at least one component (**420**) is a 3D printed Surface-Mount Component (SMT);

8. Process for manufacturing a humidity control sensor (**450**) via 3D-printing technology according to claims 5 to 7, **characterized in that** the humidity control sensor (450) is connected to a 3D printed antenna;

9. Process for manufacturing a humidity control sensor (**450**) via 3D-printing technology according to claim 5 to 8, **characterized in that** the 3D-printed antenna is a RFID (Radio Frequency Identification);

10. Process for manufacturing a humidity control sensor (**450**) via 3D-printing technology according to claims 5 to 9, **characterized in that** the IHM (**430**) can be a buzzer, and/or a display interface such as LCD or a set of Led;

11. Humidity control sensor (**450**) from a manufacturing process via 3D-printing technology according to the previous claims.

12. Implementation process of a classic electronic component during a 3D-printing of smart tool, said 3D-printer (**10**) comprising at least a robotized arm (**21**) with prehension means (**22**) and following the following steps (**100, 200, 300, 400**)
- Synchronization of the robotized arm **21** with the movement of the set of heads (**11a**, **11b**, **11c**), or the print bed (**14**).
- the prehension means (**22**) catch a classic electronic component from a receptacle,
- the prehension means (**22**) implement the said classic electronic component onto a 3D-printed PCB (**105**).
- discharge via the 3D-printing head (**11c**) a thermoplastic (**12c**) based from Polyetherimide to form a protective layer on the top of the classic electronic component, in order to protect it from ultraviolet radiations and laser beam.

13. Implementation process of a classic electronic component during a 3D-printing technology of smart tool according to claim 12, **characterized in that** the classic component is a humidity control sensor (**450**).

14. Implementation process of a classic electronic component during a 3D-printing technology of smart tool according to claim 12 to 13, **characterized in that** the Polyetherimide used in order to protect the top of the electronic component is ULTEM1010.
